# EUROPÄISCHE PATENTSCHRIFT

(11) **EP 2 957 156 B1**
(45) Veröffentlichungstag und Bekanntmachung des Hinweises auf die Patenterteilung: **24.03.2021**
(21) Anmeldenummer: 14703376.5
(22) Anmeldetag: 10.02.2014
(51) Int. Cl.: H05K 3/30, F21S 43/14, F21S 43/19, F21S 45/10, H05K 1/18, H05K 3/00

(54) **ELEKTRONISCHE BAUEINHEIT MIT EINEM HALBLEITER-LEUCHTMITTEL IN GESCHÜTZTER ANORDNUNG AUF EINEM TRÄGERKÖRPER**
ELECTRONIC UNIT WITH A SEMICONDUCTOR LIGHTING MEANS IN A PROTECTED ARRANGEMENT ON A CARRIER BODY
UNITÉ MODULAIRE ÉLECTRIQUE POURVUE D'UN MOYEN D'ÉCLAIRAGE À SEMI-CONDUCTEUR DANS UN ENSEMBLE PROTÉGÉ SUR UN CORPS DE SUPPORT

(30) Priorität: 12.02.2013 DE 102013101341
(43) Veröffentlichungstag der Anmeldung: 23.12.2015
(73) Patentinhaber: HELLA GmbH & Co. KGaA, 59552 Lippstadt (DE)
(72) Erfinder: SCHÄFER, Heinrich, 33181 Bad Wünnenberg (DE)
(86) Internationale Anmeldenummer: PCT/EP2014/052511
(87) Internationale Veröffentlichungsnummer: WO 2014/124891

(56) Entgegenhaltungen:
- EP-A1- 2 337 225
- DE-A1- 10 050 817
- US-A1- 2005 218 516
- US-A1- 2009 180 263
- US-A1- 2012 182 753

## Beschreibung

Die vorliegende Erfindung betrifft eine elektronische Baueinheit, insbesondere für eine Beleuchtungseinrichtung eines Fahrzeugs, mit wenigstens einem berührungsempfindlichen Bauteil, das an einem Trägerkörper aufgenommen ist und wenigstens abschnittsweise über der Oberfläche des Trägerkörpers hervorsteht.

### STAND DER TECHNIK

Beispielsweise zeigt die DE 10 2007 048 841 A1 eine elektronische Baueinheit, die zur Anordnung in einem Türspiegel eines Fahrzeugs vorgesehen ist, beispielsweise um die Funktion eines Richtungsanzeigers zu erfüllen. Die elektronische Baueinheit weist berührungsempfindliche Bauteile in Form von LED-Leuchtmitteln auf, und es ist grundsätzlich zu vermeiden, die LED-Leuchtmittel durch weitere Objekte insbesondere während der Montage zu berühren. Insbesondere dann, wenn die LED-Leuchtmittel ohne Gehäusekapselung ausgeführt sind, können einfache Berührungen der LED-Leuchtmittel beispielsweise durch einen beispielsweise nachträglich zu montierenden Lichtleitkörper zur Beschädigung der LED-Leuchtmittel führen.

Die EP 2 277 741 zeigt eine weitere Anordnung von LED-Leuchtmitteln in einer Beleuchtungseinrichtung eines Fahrzeugs, die Teil einer elektronischen Baueinheit sind. Die LED-Leuchtmittel sind über einem Trägerkörper frei hervorstehend auf diesem aufgenommen, und bei der Montage der elektronischen Baueinheit kann es vorkommen, dass die LED-Leuchtmittel durch den einzubauenden Lichtleitkörper berührt werden. Dadurch können die LED-Leuchtmittel Schaden nehmen

Die DE 100 50 817 A1 zeigt ein Beleuchtungssystem für Kraftfahrzeugkomponenten, das mehrere ein- oder mehradrige faseroptische, flexible Lichtleiter aufweist, die von einer Lichtquelle emittiertes Licht von einer Einkoppelseite der Lichtleiter über eine Auskoppelseite der Lichtleiter zu den Kraftfahrzeugkomponenten leitet, wobei die Lichtleiter auf der Einkoppelseite in einer Einkoppelhülse angeordnet sind.

### OFFENBARUNG DER ERFINDUNG

Aufgabe der Erfindung ist es, eine elektronische Baueinheit für eine Beleuchtungseinrichtung eines Fahrzeugs derart weiterzubilden, dass berührungsempfindliche Bauteile auf einem Trägerkörper der elektronischen Baueinheit nicht mit weiteren Objekten in Kontakt gelangen können.

Diese Aufgabe wird ausgehend von einer elektronischen Baueinheit gemäß dem Oberbegriff des Anspruches 1 in Verbindung mit den kennzeichnenden Merkmalen gelöst. Vorteilhafte Weiterbildungen der Erfindung sind in den abhängigen Ansprüchen angegeben.

Die Erfindung schließt die technische Lehre ein, das am Trägerkörper benachbart zum berührungsempfindlichen Bauteil wenigstens ein Führungskörper aufgenommen ist, wobei der Führungskörper in Form und Größe derart beschaffen ist, dass das berührungsempfindliche Bauteil durch den Führungskörper vor einer Berührung durch weitere Objekte geschützt ist, wobei das weitere Objekt ein Lichtleitkörper ist. Erfindungsmäßig ist der Führungskörper als ein SMD-Bauteil ausgeführt und auf der Oberfläche des Trägerkörpers aufgebracht.

Die Erfindung geht von dem Gedanken aus, das berührungsempfindliche Bauteil dadurch zu schützen, dass ein Führungskörper benachbart zum berührungsempfindlichen Bauteil angeordnet wird, und weitere Objekte, die beispielsweise im Rahmen einer Montage oder einer sonstigen Handhabung der elektronischen Baueinheit in die Nähe oder an das berührungsempfindliche Bauteil gelangen können, werden vom Führungskörper am berührungsempfindlichen Bauteil vorbei oder über diesen hinweg geführt. Im Ergebnis wird eine Kollision des weiteren Objektes mit dem berührungsempfindlichen Bauteil vermieden, da stets der Führungskörper zuerst mit dem weiteren Objekt in Kontakt gelangt, bevor das weitere Objekt das berührungsempfindliche Bauteil berührt.

Eine benachbarte Anordnung des Führungskörpers zum berührungsempfindlichen Bauteil liegt bereits dann vor, wenn der Führungskörper zumindest in der Nähe des berührungsempfindlichen Bauteils auf dem Trägerkörper angeordnet ist. Der Führungskörper kann sogar das berührungsempfindliche Bauteil berühren oder dieses wenigstens teilweise umschließen. Jedenfalls liegt dann eine benachbarte Anordnung vor, wenn der Führungskörper mit seiner Form und seiner Größe eine Berührung des berührungsempfindlichen Bauteils durch weitere Objekte vermeiden kann. Im besten Fall kann der Führungskörper so angrenzend an das berührungsempfindliche Bauteil auf dem Trägerkörper angeordnet sein, dass der Führungskörper an das berührungsempfindliche Bauteil beispielsweise seitlich angrenzt. Auch ist es denkbar, dass der Führungskörper um das berührungsempfindliche Bauteil herum ausgeführt ist, ohne Teil des berührungsempfindlichen Bauteils selbst zu sein.

Beispielsweise kann der Führungskörper das berührungsempfindliche Bauteil in seiner Bauhöhe über der Oberfläche des Trägerkörpers überragen. Dabei kann es ausreichend sein, dass der Führungskörper wenigstens geringfügig höher über dem Trägerkörper baut als das berührungsempfindliche Bauteil. Das weitere Objekt kann beispielsweise ein Lichtleitkörper sein, der händisch, mit einer Vorrichtung oder maschinell an die elektronische Baueinheit gefügt wird. Beim Fügen können Seitenbewegungstoleranzen auftreten, die dazu führen können, dass das weitere Bauteil in Richtung zum berührungsempfindlichen Bauteil bewegt wird. Baut der Führungskörper geringfügig höher als das berührungsempfindliche Bauteil, so ist bereits eine Berührung des berührungsempfindlichen Bauteils durch den Lichtleitkörper vermieden.

Werden Objekte als weitere Bestandteile der elektronischen Baueinheit an diese gefügt, so kann eine Fügerichtung berücksichtigt werden, und der Führungskörper befindet sich in Fügerichtung räumlich vor der Anordnung des berührungsempfindlichen Bauteils. Wird folglich das weitere Objekt an die Baueinheit herangeführt, erfolgt immer zuerst eine Berührung mit dem Führungskörper, bevor eine Berührung mit dem berührungsempfindlichen Bauteil stattfinden kann.

Erfindungsmäßig ist das berührungsempfindliche Bauteil durch ein Halbleiterleuchtmittel gebildet. Halbleiterleuchtmittel werden vorzugsweise durch SMDmontierte Leuchtdioden gebildet, die häufig kein eigenes Gehäuse aufweisen. Der Halbleiteremitter liegt dabei frei, und bereits eine einfache Berührung durch ein weiteres Objekt kann zur Beschädigung des Halbleiteremitters führen.

Die elektronische Baueinheit kann beispielsweise eine Elektronikplatine aufweisen, und der Trägerkörper zur Aufnahme des berührungsempfindlichen Bauteils und des Führungskörpers kann durch die Elektronikplatine gebildet sein. Die Elektronikplatine kann auf einem Grundkörper angeordnet sein, insbesondere wenn diese als flexibles Leitersubstrat ausgebildet ist.

Mit weiterem Vorteil kann der Führungskörper selbst eine elektronische Funktion der elektronischen Baueinheit erfüllen. Beispielsweise kann der Führungskörper eine Spule, ein Kondensator, ein Widerstand, eine Sicherung, ein Halbleiterbauteil, eine Drossel oder beispielsweise ein Ferritkern oder dergleichen sein. Vorzugsweise weist der Führungskörper eine kubische oder zylindrische Form auf und bildet einen Festkörper, der in seiner Form und Größe starr auf dem Trägerkörper aufgebracht ist.

Der Führungskörper kann derart ausgebildet sein, dass dieser eine Führung und/oder einen Anschlag für das weitere Objekt bildet. Beispielsweise kann das weitere Objekt ein Bauteil bilden, welches ebenfalls an den Trägerkörper oder relativ zum Trägerkörper als Bestandteil der elektronischen Baueinheit montiert oder auf diesem aufgelötet wird. Der Führungskörper kann dabei die Aufgabe erfüllen, beispielsweise eine bestimmte relative Position des weiteren Objektes zum berührungsempfindlichen Bauteil einzustellen, insbesondere dann, wenn der Führungskörper beispielsweise als Anschlag dient. Die Anschlagfunktion kann dabei senkrecht zur Oberfläche des Trägerkörpers wirken, jedoch kann auch eine Anschlagfunktion beispielsweise in Fügerichtung des weiteren Objektes erfolgen, und die Fügerichtung kann beispielsweise quer zur Erstreckungsrichtung des berührungsempfindlichen Bauteils über der Oberfläche des Trägerkörpers ausgerichtet sein. Folglich kann mit weiterem Vorteil der Führungskörper derart beschaffen sein, dass durch diesen eine Montagerichtung für das weitere Objekt vorgegeben ist. Ein oder mehrere Führungskörper können insbesondere relativ zum berührungsempfindlichen Bauteil so auf dem Trägerkörper angeordnet sein, dass das weitere Objekt nur aus einer durch den Führungskörper vorgegebenen Richtung an die elektronische Baueinheit montiert werden kann. Bei dieser Montage sind die Führungskörper des Weiteren so beschaffen, dass eine Berührung des berührungsempfindlichen Bauteils durch das weitere Objekt zugleich vermieden ist.

Auch ist es von Vorteil, dass das berührungsempfindliche Bauteil und/oder der Führungskörper jeweils als SMD-Bauteile ausgeführt sind und auf der Oberfläche des Trägerkörpers aufgebracht sind. Die sogenannten Surface-Mounted-Devices bilden Bauteile, die auf der Oberfläche einer Elektronikplatine insbesondere durch Löten aufgebracht und befestigt werden. Die haltende Anordnung des SMD-Bauteils auf der Elektronikplatine erfolgt dabei bereits durch die elektrische Kontaktierung selbst, die meist durch ein Lot gebildet ist.

### BEVORZUGTE AUSFÜHRUNGSBEISPIELE DER ERFINDUNG

Weitere, die Erfindung verbessernde Maßnahmen werden nachstehend gemeinsam mit der Beschreibung bevorzugter Ausführungsbeispiele der Erfindung anhand der Figuren näher dargestellt. Es zeigt:
- Fig. 1: ein Ausführungsbeispiel einer elektronischen Baueinheit mit einem berührungsempfindlichen Bauteil in Form eines Halbleiterleuchtmittels,
- Fig. 2: eine Seitenansicht der elektronischen Baueinheit gemäß Figur 1,
- Fig. 3: ein weiteres Ausführungsbeispiel einer elektronischen Baueinheit in einer perspektivischen Ansicht und
- Fig. 4: eine Seitenansicht des Ausführungsbeispiels der elektronischen Baueinheit gemäß Figur3.

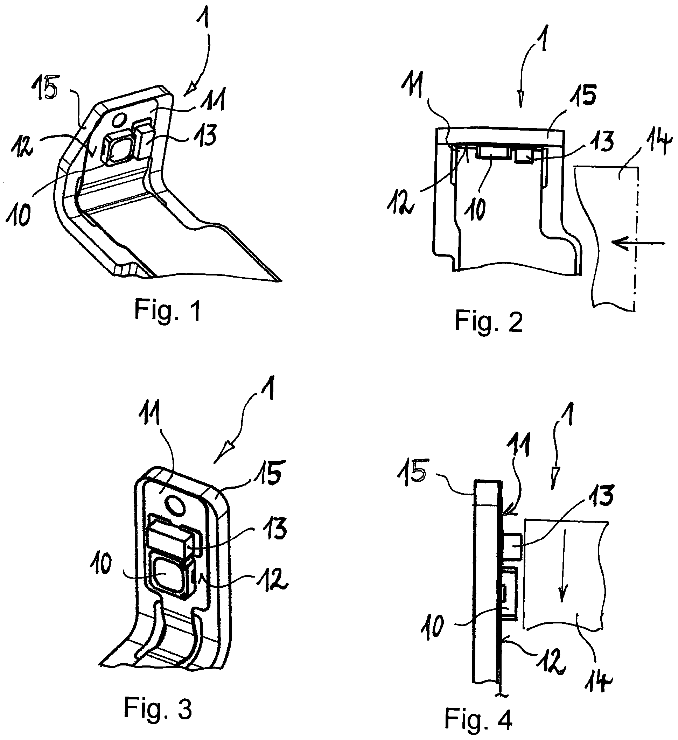

Die Figuren 1 und 2 zeigen ein erstes Ausführungsbeispiel einer elektronischen Baueinheit 1, die in einer Beleuchtungseinrichtung eines Fahrzeugs zum Einsatz kommen kann. Die Baueinheit 1 umfasst ein berührungsempfindliches Bauteil 10, das als Halbleiterleuchtmittel 10 ausgeführt ist. Das Halbleiterleuchtmittel 10 ist auf einem Trägerkörper 11 aufgebracht, der beispielhaft als flexibles Leitersubstrat ausgebildet ist und der Trägerkörper 11 ist auf einem Grundkörper 15 aufgenommen, der beispielsweise aus einem abgewinkelten Aluminiumbauteil besteht, um beispielsweise eine Entwärmung des Halbleiterleuchtmittels 10 zu ermöglichen.

Benachbart zum berührungsempfindlichen Bauteil 10 ist ein Führungskörper 13 gezeigt, der, wie aus Figur 2 ersichtlich, über der Oberfläche 12 des Trägerkörpers 11 eine größere Bauhöhe aufweist als das berührungsempfindliche Bauteil 10. Weiterhin gezeigt ist ein weiteres Objekt 14, das ein Lichtleitkörper ist, in den Licht des Halbleiterleuchtmittels einkoppelbar ist.

Das weitere Objekt 14 wird aus einer Fügerichtung an die Baueinheit 1 geführt, und die Fügerichtung ist beispielhaft durch einen Pfeil angedeutet. Das Ausführungsbeispiel zeigt dabei den Führungskörper 13, der sich in Bezug auf die Fügerichtung des weiteren Objektes 14 räumlich vor der Anordnung des berührungsempfindlichen Bauteils 10 auf dem Trägerkörper 11 befindet. Wird das weitere Objekt 14 beispielsweise mit einer Seitentoleranz an die Baueinheit 1 gefügt, so wird durch den Führungskörper 13 wirkungsvoll verhindert, dass das weitere Objekt 14 das berührungsempfindliche Bauteil 10 berührt. Das Objekt 14 ist als Lichtleitkörper ausgebildet, und das berührungsempfindliche Bauteil 10 ein Halbleiterleuchtmittel 10 bildet, wobei das Licht in den Lichtleitkörper 14 eingekoppelt ist.

Die Figuren 3 und 4 zeigen ein weiteres Ausführungsbeispiel der elektronischen Baueinheit 1 mit einem Trägerkörper 11 in Form eines flexiblen Leitersubstrates, das auf einem starren Grundkörper 15 aufgebracht ist. Die Anordnung des berührungsempfindlichen Bauteils 10 auf der Oberfläche 12 des Trägerkörpers 11 befindet sich unterhalb eines Führungskörper 13, und wird ein weiteres Objekt 14, wie in Figur 4 gezeigt, aus einer Fügerichtung gemäß der gezeigten Pfeilrichtung an die Baueinheit 1 herangeführt, so verhindert der oberhalb des berührungsempfindlichen Bauteils 10 angeordnete Führungskörper 13 einen Kontakt des weiteren Objektes 14 mit dem berührungsempfindlichen Bauteil 10. Auch gemäß diesem Aufführungsbeispiel ist das berührungsempfindlichen Bauteil 10 durch ein Halbleiterleuchtmittel 10 gebildet und das weitere Objekt 14 bildet einen Lichtleitkörper. Die benachbarte Anordnung des Führungskörper 13 zum berührungsempfindlichen Bauteil 10 weist einen Abstand auf, der wenigstens kleiner ist als die Hauptabmessung des berührungsempfindlichen Bauteils 10 oder des Führungskörper 13 über der Oberfläche 12 des Trägerkörpers 11. Sowohl das berührungsempfindliche Bauteil 10 als auch der Führungskörper 13 sind als SMD-Bauteile ausgeführt, wobei der Führungskörper 13 ebenfalls eine elektronische Funktion in der elektronischen Baueinheit 1 erfüllen kann.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

### Bezugszeichenliste

- 1: elektronische Baueinheit

- 10: berührungsempfindliches Bauteil, Halbleiterleuchtmittel
- 11: Trägerkörper, Elektronikplatine
- 12: Oberfläche des Trägerkörpers
- 13: Führungskörper
- 14: weiteres Objekt, Lichtleitkörper
- 15: Grundkörper

## Patentansprüche

1. Elektronische Baueinheit (1) für eine Beleuchtungseinrichtung eines Fahrzeugs, mit wenigstens einem berührungsempfindlichen Bauteil (10), das durch ein Halbleiterleuchtmittel (10) gebildet ist und das an einem Trägerkörper (11) aufgenommen ist und wenigstens abschnittsweise über der Oberfläche (12) des Trägerkörpers (11) hervorsteht, wobei am Trägerkörper (11) benachbart zum Halbleiterleuchtmittel (10) wenigstens ein Führungskörper (13) aufgenommen ist, wobei der Führungskörper (13) in Form und Größe derart beschaffen ist, dass das Halbleiterleuchtmittel (10) durch den Führungskörper (13) vor einer Berührung durch weitere Objekte (14) geschützt ist, und wobei das weitere Objekt (14) ein Lichtleitkörper ist, in den Licht des Halbleiterleuchtmittels (10) einkoppelbar ist,
**dadurch gekennzeichnet, dass** der Führungskörper (13) als SMD-Bauteil ausgeführt und auf der Oberfläche des Trägerkörpers (11) aufgebracht ist.

2. Elektronische Baueinheit (1) nach Anspruch 1, **dadurch gekennzeichnet, dass** der Führungskörper (13) das berührungsempfindliche Bauteil (10) in seiner Bauhöhe über der Oberfläche (12) des Trägerkörpers (11) überragt.

3. Elektronische Baueinheit (1) nach einem der Ansprüche 1 oder 2, **dadurch gekennzeichnet, dass** der Trägerkörper (11) durch eine Elektronikplatine (11) gebildet ist.

4. Elektronische Baueinheit (1) nach einem der Ansprüche 1 bis 3, **dadurch gekennzeichnet, dass** der Führungskörper (13) eine elektronische Funktion der elektronischen Baueinheit (1) erfüllt.

5. Elektronische Baueinheit (1) nach einem der vorgenannten Ansprüche, **dadurch gekennzeichnet, dass** der Führungskörper (13) derart ausgebildet ist, dass dieser eine Führung und/oder einen Anschlag für das weitere Objekt (14) bildet.

6. Elektronische Baueinheit (1) nach einem der vorgenannten Ansprüche, **dadurch gekennzeichnet, dass** der Führungskörper (13) derart beschaffen ist, dass durch diesen eine Montagerichtung für das weitere Objekt (14) vorgegeben ist.

7. Elektronische Baueinheit (1) nach einem der vorgenannten Ansprüche, **dadurch gekennzeichnet, dass** das berührungsempfindliche Bauteil (10) auf der Oberfläche des Trägerkörpers (11) aufgebracht ist.

## Claims

1. Electronic assembly (1) for an illumination device of a vehicle with at least one touch-sensitive component (10) that is formed by a semiconductor light source (10) and that is accommodated on a carrier body (11) and protrudes at least in sections above the surface (12) of the carrier body (11), where at least one guiding body (13) is accommodated on the carrier body (11) adjacent to the semiconductor light source (10), where the guiding body (13) is made in such a way in terms of shape and size that the semiconductor light source (10) is protected by the guiding body (13) from coming into contact with other objects (14) and where the further object (14) is a light guiding body into which the light from the semiconductor light source (10) can be incoupled,
**characterized in that**
the guiding body (13) is implemented as an SMD component and is mounted on the surface of the carrier body (11).

2. Electronic assembly (1) in accordance with Claim 1, **characterized in that** the guiding body (13) projects beyond the touch-sensitive component (10) in terms of its height above the surface (12) of the carrier body (11).

3. Electronic assembly (1) in accordance with one of Claims 1 or 2, **characterized in that** the carrier body (11) is formed by an electronic printed circuit board (11).

4. Electronic assembly (1) in accordance with one of Claims 1 through 3, **characterized in that** the guiding body (13) performs an electronic function of the electronic assembly (1).

5. Electronic assembly (1) in accordance with one of the aforementioned Claims, **characterized in that** the guiding body (13) is formed in such a way that it forms a guide and/or a limit stop for the further object (14).

6. Electronic assembly (1) in accordance with one of the aforementioned Claims, **characterized in that** the guiding body (13) is made in such a way that it predefines an installation direction for the further object (14).

7. Electronic assembly (1) in accordance with one of the aforementioned Claims, **characterized in that** the touch-sensitive component (10) is mounted on the surface of the carrier body (11).

## Revendications

1. Unité électronique (1) pour un dispositif d'éclairage d'un véhicule comportant au moins un composant sensible au toucher (10) constitué d'une ampoule à semi-conducteur (10) logée sur un support (11) et dépassant au moins par endroits de la surface (12) du support (11) dans lequel au moins un corps de guidage (13) est logé sur le support (11) à côté de l'ampoule à semi-conducteur (10), le corps de guidage (13) ayant une forme et une taille telles que l'ampoule à semi-conducteur (10) est protégée par le corps de guidage (13) contre tout contact avec d'autres objets (14) et dans lequel l'autre objet (14) est un guide de lumière dans lequel la lumière de l'ampoule à semi-conducteur (10) peut être couplée,
**caractérisée en ce que**
**en ce que** le corps de guidage (13) est conçu comme composant CMS et monté sur la surface du support (11).

2. Unité électronique (1) selon la revendication 1, **caractérisée en ce que** le corps de guidage (13) dépasse de la surface (12) du support (11) dans sa hauteur totale au-dessus du composant sensible au toucher (10).

3. Unité électronique (1) selon l'une des revendications 1 ou 2, **caractérisée en ce que** le support (11) est constitué par une carte électronique (11).

4. Unité électronique (1) selon l'une des revendications 1 à 3, **caractérisée en ce que** le corps de guidage (13) remplit une fonction électronique de l'unité électronique (1).

5. Unité électronique (1) selon l'une des revendications précédentes, **caractérisée en ce que** le corps de guidage (13) est conçu de sorte à former un guide et/ou une butée pour l'autre objet (14).

6. Unité électronique (1) selon l'une des revendications précédentes, **caractérisée en ce que** le corps de guidage (13) est tel qu'il détermine une direction de montage pour l'autre objet (14).

7. Unité électronique (1) selon l'une des revendications précédentes, **caractérisée en ce que** le composant sensible au toucher (10) est monté sur la surface du support (11).
